# EUROPEAN PATENT SPECIFICATION

(11) **EP 1 111 690 B1**
(45) Date of publication and mention of the grant of the patent: **26.08.2009**
(21) Application number: 99830795.3
(22) Date of filing: 23.12.1999
(51) Int. Cl.: H01L 33/00, H01L 31/0203

(54) **method for easily assembling a photocell**
Methode für den einfachen Zusammenbau einer Photozelle
méthode pour l'assemblage facile d'une photocellule

(43) Date of publication of application: 27.06.2001
(73) Proprietor: Datasensor S.p.A., 40050 Monte San Pietro (Bologna) (IT)
(72) Inventor: Brancaleoni, Maurizio, 40055 Castenaso (Bologna) (IT)
(74) Representative: Kratter, Carlo

(56) References cited:
- US-A- 4 755 666
- US-A- 5 198 664
- PATENT ABSTRACTS OF JAPAN vol. 006, no. 136 (E-120), 23 July 1982 (1982-07-23) & JP 57 062574 A (TOSHIBA CORP), 15 April 1982 (1982-04-15)
- PATENT ABSTRACTS OF JAPAN vol. 010, no. 201 (E-419), 15 July 1986 (1986-07-15) & JP 61 042970 A (SEIKO INSTR & ELECTRONICS LTD), 1 March 1986 (1986-03-01)

## Description

This invention relates to a method for assembling a photocell in accordance with the precharacterising part of the main claim.

In the present context the term "resin-coating" is meant to signify the usual process used for insulating the electronic components of a device, consisting of completely covering these components with a synthetic resin or another known insulating material suitable for the purpose.

When resin-coating the internal components of known photocells, the printed circuit has to be maintained in a predetermined position. For this purpose it is known to secure the printed circuit to the optical unit of the photocell, which in this manner acts as a support element for the printed circuit during resin-coating. This solution is however relatively complicated and negatively affects the overall assembly time of the photocell, because it means that the printed circuit has to be secured to the optical unit before its insertion into the photocell, and that the optical unit has to be protected before resin-coating by positioning at least two gaskets to prevent the resin from depositing on the photo elements.

It is known from JP57062574 in order to improve the performance of a semiconductor element, in particular a photointerrupter, to provide on said semiconductor element an enclosure comprising flexible projection which may accurately held said element to the enclosure.

It is also known from US 4,755,666 to provide a photo sensor with a flexible frame for protecting said photo sensor from light penetrating into a photoelectric conversion device through narrow lateral faces of a transparent support substrate.

It is also known from US 5,198,664 to provide a photoelectric sensor comprising a one piece threaded barrel housing all the components of said sensor.

An object of the invention is to provide a method for assembling a photocell which simplifies the operations involved in resin-coating the printed circuit of the photocell.

These and further objects which will be apparent to an expert of the art are attained by a method in accordance with the characterising part of the main claim.

The invention will be more apparent from the accompanying drawings, which are provided by way of non-limiting example and on which:
Figure 1 is a perspective view of a photoelectric cell of the invention;
Figure 2 is an exploded perspective view thereof;
Figures 3-6 are schematic perspective views of the photoelectric cell components during the various stages of its assembly;
Figures 7, 7A, 7B, 7C are a schematic cross-section through the central portion of the photoelectric cell of Figure 1 and of a first, a second and a third variant;
Figure 8 is a schematic exploded perspective view of a second embodiment;
Figure 9 is an exploded perspective view of some components thereof;
Figure 10 is a schematic cross-section through its central portion;
Figure 11 is a partial schematic view of a further embodiment seen from above.

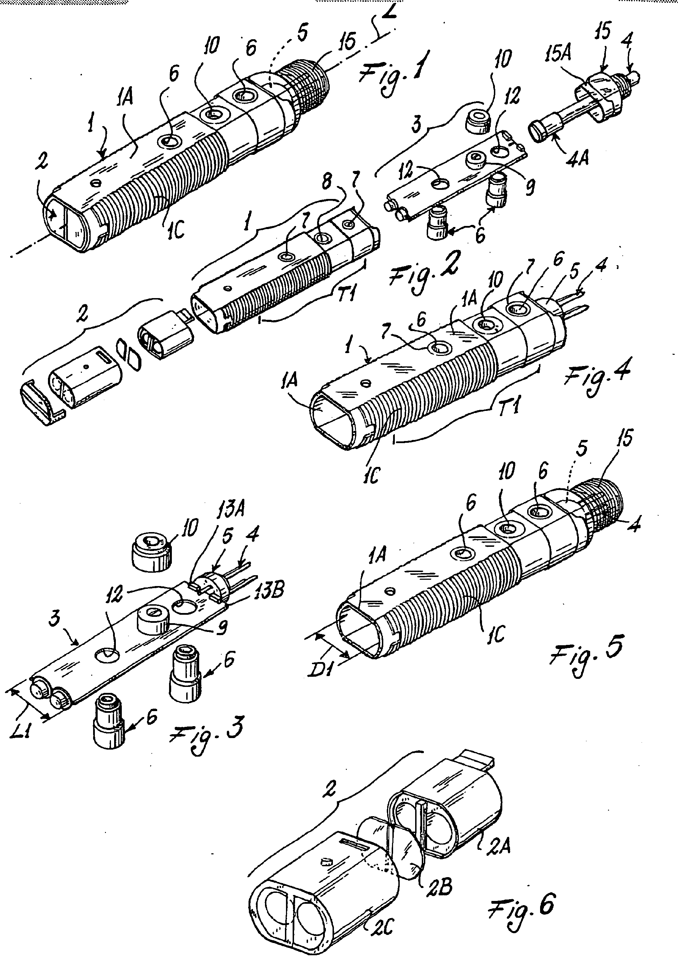

With reference to Figures 1-7, a photoelectric cell of the invention comprises a casing 1 for containing and protecting the cell components, namely an optical unit 2, a printed circuit 3, a connection element 4 and elements 6 for supporting and positioning the circuit 3 within said casing 1.

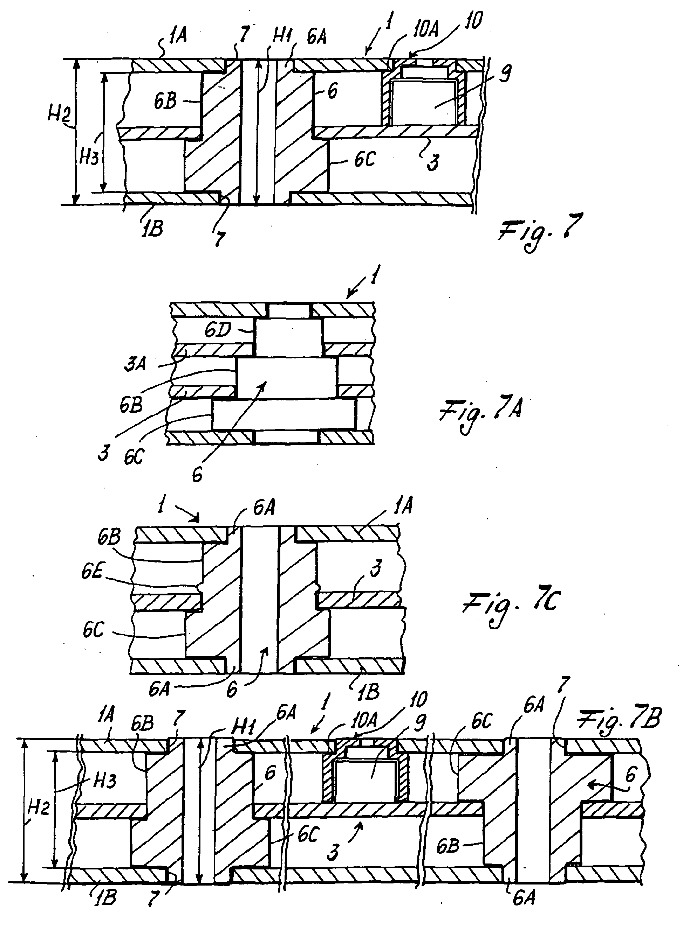

In the illustrated example the cell casing 1 is of substantially tubular shape to define a seat 1A, and is formed, at least within that portion T1 housing the printed circuit 3, of an elastically deformable material such as ABS or PBT. Within this portion T1 the body comprises, in two opposing walls 1A, 18 (Figure 7), two pairs of coaxial through holes 7 (Figure 2) acting as seats for end portions 6A (Figure 7) of the support elements 6 for the printed circuit, and, in the upper wall 1A, a through hole 8 for a protection cap 10 of a potentiometer (trimmer) 9 for the printed circuit 3. On its outer face the cap 10 comprises a step 10A which abuts against the inner face of the wall 1A of the body 1, to prevent the printed circuit undergoing any movement towards this wall when positioned in the body 1. It should be noted that the cap 10 is dimensioned such that its end lies flush with or slightly inward of the outer face of the wall 1A. Advantageously if, in accordance with a variant (not shown), only the cap 10 acts as a support for the printed circuit 3, as is also described hereinafter, it is preferably rigidly fixed, for example by gluing or ultrasonic welding, to the printed circuit and to the edge of the hole 8 of the body 1 into which it is inserted, or is fitted into this hole 8 as an interference fit, such as to be rigidly connected to the edge of the hole 8.

Preferably those two opposing walls 1A, 1B of the body 1 containing the through holes 7 and 8 are flat and parallel, whereas the said walls 1C are curved and comprise an external thread to enable the photocell to be screwed to a conventional support member.

The printed circuit 3 comprises two through holes 12 (Figure 2) to be penetrated by an intermediate portion 6B (Figure 7) of the support elements 6. Advantageously, the holes 12 and the supports 6 are dimensioned such that the printed circuit 3 and the supports 6 are connected together by an interference fit. i.e. the intermediate portion 6B of the supports 6 has to be forced into the holes 12, the circuit hence being engaged with said supports by forcing. The printed circuit 3 is substantially flat, with its width L1 being less than the distance D1 between the side walls 1C of the body 1, so as to be able to be inserted into said body.

The printed circuit 3 is substantially of conventional type, comprising a plurality of usual electronic components which will not be described in detail but which include: photodiodes 11, diodes 13A, B (Figure 3) to indicate the operating state of the photocell, the potentiometer 9, and the element 4 for its connection to a power control and supply unit. This element can be either a conventional plug (Figures 1, 3, 4, 5) or an electric cable (Figure 2).

The plug or cable extends from a disc element 5 secured to the printed circuit to close the seat into which the printed circuit is inserted and to prevent the circuit shifting vertically within the body during resin-coating. The connection elements are protected by a cover 15 which is advantageously transparent to enable the LEDs 13A, 13B indicating the cell operating state to be seen.

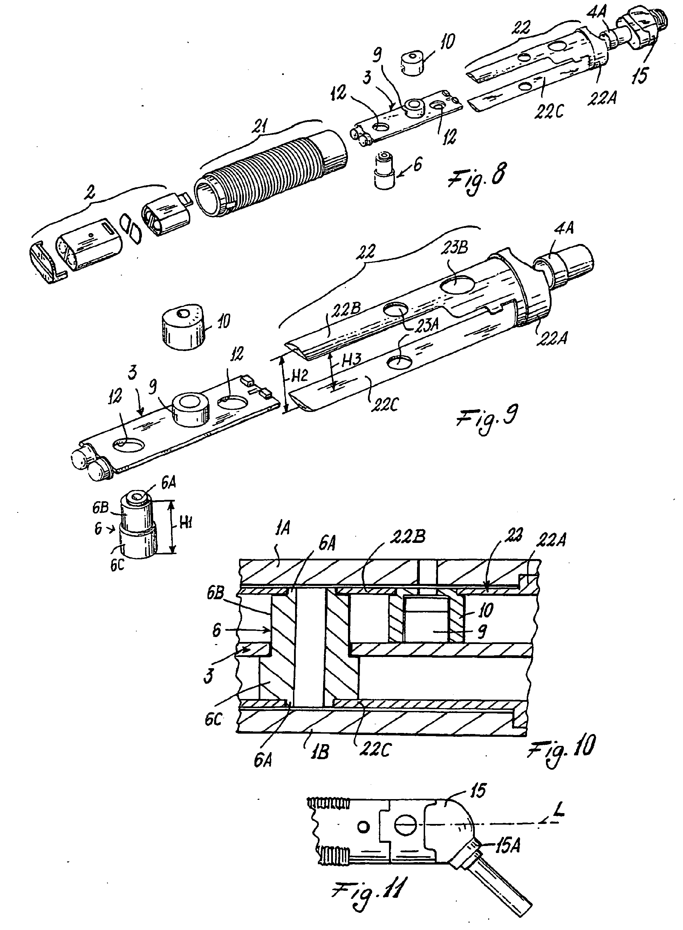

The cover element 15 can be tubular in shape and have an external thread (Figures 1, 5), or comprise a spherical head with a cable exit 15A coaxial to the longitudinal axis L (Figure 2) of the photocell or inclined to this axis (Figure 11) by an angle of between 30° and 60°, and preferably about 45°. The cover element 15 has its free edge 15A (Figure of the same shape as the cross-section through the seat of the body 1, so as to be able to be sealedly inserted thereinto after being mounted on the disc 5. It should be noted that the solution of providing a cover with the axis of its electric cable exit inclined at an angle of between 30° and 60°, and preferably of 45°, does not form part of the known art and is particularly advantageous because it enables the cable, by slight bending, to be positioned either coaxial or perpendicular to the photocell, and facilitates the connection to a support.

It should also be noted that the two aforedescribed new solutions. namely a transparent cover 15 and a 45°-inclined exit 15A for the cable 4 could also be used in known photocells, i.e. in photocells with printed circuit support and positioning elements different from those described in this patent text.

The optical unit 2 is of conventional type and comprises an optical chamber 2A, a filter 2B and a lens 2C. The unit is inserted into the front part of the seat.

The printed circuit support and positioning elements 6 are substantially cylindrical and comprise end portions 6A to penetrate holes 7 provided in the outer surfaces 1A, 1B of the body 1 and lie flush with these latter, an intermediate portion 6B to penetrate the holes 12 in the printed circuit, and a portion 6C of greater diameter than the intermediate portion 68 and having its upper edge acting as a support surface for the printed circuit.

The height H1 (Figure 7) of the elements 6 is preferably equal to the distance H2 between the outer faces of the two surfaces 1A, 1B. The height H1 of the elements 6 could however also be slightly less than the distance H2, but in any event greater than the distance H3 between the opposing inner faces of the surfaces 1A, 1B. This ensures that the ends 6A of the elements 6 engage in the holes 7 of the body 6 without projecting beyond the outer surface of the body and hence prevent the photocell being screwed into a threaded seat or flushingly inserted into a seat of cross-section equal to the outer cross-section of the cell.

If the body 1 of the photocell is cylindrical and is externally threaded, the ends of the support elements 6 could be curved and have a thread equal to that of said outer surface. Moreover, as shown in Figure 7A, the support elements 6 could have a plurality of superposed coaxial intermediate parts 68, 6D of gradually decreasing diameter, to be able to support a plurality of printed circuits 3, 3A (having holes 12 of correspondingly decreasing diameter) positioned parallel to each other, and/or flat screening elements.

A photocell of the invention can be assembled very easily and quickly. This is done by inserting the supports 6 into the holes 12 in the printed circuit 3, mounting the cover cap 10 on the potentiometer 9 (Figure 3), then deforming the body 1 by pressing the two side walls 1C towards each other to increase the distance H3 (Figure 7) between the walls 1A and 1B comprising the holes 7 and enable the circuit 3 with its supports 6 to be inserted into the body 1 and the ends 6A of the supports 6 to be positioned facing the holes 7. At this point, the pressure on the side walls of the body 1 is released with the result that this returns elastically to its initial position, to properly connect the support elements 6, the cover cap 10 and the disc element 5 to the inner faces of the walls defining the seat 1A in the body 1. Any longitudinal movement of the printed circuit is prevented by the support elements 6, any transverse movement of the circuit being prevented by the cover cap 10 and the disc element 5. By inserting the two support elements 6 in mutually inverted positions (as in Figure 7B), these support elements prevent both transverse and longitudinal movement, without the need for action in this sense by the cap 10 and the closure disc 5. Alternatively the support elements could comprise between the intermediate part 6B and the lower part 6C an annular projection 6E (Figure 7C) for preventing vertical movement of the printed circuit, ie movement coaxial to these supports. With this latter solution, a single support element is sufficient to lock the printed circuit within the body 1 both longitudinally and transversely.

Hence according to the invention, a single support element 6 is sufficient to ensure stable positioning of the printed circuit during the intermediate stages in the assembly of the photocell, prior to resin-coating. When the printed circuit has been positioned and the transparent cover element 15 has been fitted to the body 1, resin can be poured into the body. Advantageously, before resin-coating, the ends of the supports 6 are rigidly secured to those edges bounding the apertures 7 of the body 1 into which said ends are inserted. Preferably the ends of the supports 6 are secured to the body 1 by ultrasonic welding. This ensures that the body 1 is perfectly sealed during resin-coating. After this stage, the assembly of the photocell is completed by fitting the previously assembled optical unit 2 to the body 1.

Figures 8 and 9 show a second embodiment of the invention in which those elements in common with the already described embodiment are not further described, and are indicated in Figures 8 and 9 by the reference numerals already used for these in Figures 1-7. In this second embodiment the body of the photocell is a substantially rigid tubular element 21, in the interior of which, in addition to the already described components, there is an elastically deformable support element 22 comprising an undeformable substantially rigid annular part 22A and two opposing strip elements 228, C connected elastically to the annular part such as to be able to be at least partially eased apart, to then return to their initial rest position. The annular part 22A is inserted into the seat in the body 21, to adhere to the circular wall bounding this seat. When in this position the walls of the strip elements 22B, C are substantially in contact with the inner circular wall of the seat in the body 21. To assemble the photocell the printed circuit is associated with the support element 22 by easing apart its strip elements 22B, C and making the ends 6A of the support 6 and of the cap 10 penetrate respectively into holes 23A, 23B in these strip elements. At this point the support element is inserted into the body 21 and the assembly of the photocell continues as heretofore described. Advantageously, a single support element 6 is sufficient to fix the circuit 3 to the elastic support element 22.

Both the embodiments heretofore described enable the printed circuit to be quickly and reliably fixed into the cell body in the desired position prior to resin-coating. In this manner, the operations involved in the photocell assembly are extremely simplified and require less time than known photocells. Moreover, as the photocell of the invention enables the optical unit to be mounted after resin-coating, different optical units can be mounted in one and the same cell body, and as this can be done after resin-coating considerable cost saving can be achieved in terms of storage. In this respect, it is no longer necessary to hold in store a stock of photocells with different optical units, it being sufficient to stock resin-coated cell bodies into which the required optical unit is inserted only on ordering.

Finally it should be noted that the aforedescribed embodiments are provided by way of example, and that numerous variants are possible all falling within the same inventive concept. For example, instead of holes 7, cavities could be provided in the body which open towards the interior of the body seat 1A, to receive the ends 6A of the support elements 6. Likewise the support elements 6 and the cover caps 10 for the potentiometer 9 could, instead of being removably connected to the printed circuit 3, be formed integral with said circuit or be rigidly secured to it, for example by gluing or welding.

## Claims

1. A method for assembling a photocell, comprising the positioning of a printed circuit (3) within a body (1, 22) in a defined position by engaging at least one support element (6) with said circuit and said body (1, 22) and then resin-coating said circuit when in said predefined position, **characterised by** elastically deforming said body (1, 22) in order to be able to position said circuit (3) and said at least one support element (6) in said predefined position, then returning said body (1, 22) to its undeformed state after said positioning, prior to resin-coating.

2. A method as claimed in claim 1, **characterised by** connecting the support element (6) with the printed circuit (3) before elastically deforming the body (1, 22).

3. A method as claimed in claim 1, c:haracterised by connecting an optical unit (2) with the body (1) after the printed circuit has been positioned and resin-coated.

4. A method as claimed in claim 1, **characterised by** inserting the body (22) with which the printed circuit (3) is associated into a further body (21).

5. A method as claimed in claim 1, **characterised by** rigidly fixing and sealing the support element (6) tc the body (1, 22) in such a manner as to prevent resin escaping from said body (1, 22) during resin-coating.

## Patentansprüche

1. Verfahren zum Zusammenbau einer Fotozelle, umfassend die Positionierung einer gedruckten Schaltung (3) innerhalb eines Gehäuses (1, 22) in einer bestimmten Position durch Ineinandergreifen zumindest eines Trägerelementes (6) mit besagter Schaltung und besagtem Gehäuse (1, 22) und anschließendem Resin-Beschichten besagter Schaltung, wenn sich diese in besagter vorbestimmter Position befindet, **gekennzeichnet durch** elastische Deformation besagten Gehäuses (1, 22) um besagte Schaltung (3) und besagtes zumindest eine Trägerelement (6) in besagter vorbestimmter Position positionieren zu können und anschließendes Zurückkehren besagten Gehäuses (1,22) in dessen undeformierten Zustand nach besagter Positionierung vor der Beschichtung mit Resin.

2. Verfahren nach Anspruch 1, **gekennzeichnet durch**
ein Verbinden des Trägerelementes (6) mit der gedruckten Schaltung (3) vor dem elastischen Deformieren des Gehäuses (1, 22).

3. Verfahren nach Anspruch 1, **gekennzeichnet durch**
ein Verbinden einer optischen Einheit (2) mit dem Gehäuse (1) nachdem die gedruckte Schaltung positioniert und mit Resin beschichtet wurde.

4. Verfahren nach Anspruch 1, **gekennzeichnet durch**
ein Einsetzen des Gehäuses (22), mit dem die gedruckte Schaltung (3) verbunden ist, in ein weiteres Gehäuse (21).

5. Verfahren nach Anspruch 1, **gekennzeichnet durch**
ein starres Befestigen und Abdichten des Trägerelementes (6) gegenüber dem Gehäuse (1, 22) derart, dass verhindert wird, dass Resin aus besagtem Gehäuse (1, 22) während des Beschichtens mit Resin entweicht.

## Revendications

1. Procédé pour assembler une cellule photoélectrique, comprenant les étapes consistant à positionner un circuit imprimé (3) dans un corps (1, 22) dans une position définie par la mise en prise d'au moins un élément de support (6) avec ledit circuit et ledit corps (1, 22) et ensuite déposer une résine sur ledit circuit lorsqu'il est dans ladite position prédéfinie, **caractérisé par** les étapes consistant à déformer élastiquement ledit corps (1, 22) afin d'être capable de positionner ledit circuit (3) et ledit au moins un élément de support (6) dans ladite position prédéfinie, ramener ensuite ledit corps (1, 22) dans son état non déformé après ledit positionnement, avant le dépôt de la résine.

2. Procédé selon la revendication 1, **caractérisé par** l'étape consistant à relier l'élément de support (6) au circuit imprimé (3) avant la déformation élastique du corps (1, 22).

3. Procédé selon la revendication 1, **caractérisé par** l'étape consistant à relier une unité optique (2) au corps (1) après le positionnement du circuit imprimé et le dépôt de la résine.

4. Procédé selon la revendication 1, **caractérisé par** l'étape consistant à insérer le corps (22) auquel le circuit imprimé (3) est associé dans un autre corps (21).

5. Procédé selon la revendication 1, **caractérisé par** l'étape consistant à fixer rigidement et sceller l'élément de support (6) au corps (1, 22) de manière à empêcher que la résine ne s'échappe dudit corps (1, 22) pendant le dépôt de la résine.
